# EUROPEAN PATENT APPLICATION

(11) **EP 1 853 104 A1**
(43) Date of publication of application: **07.11.2007**
(21) Application number: 06113587.7
(22) Date of filing: 05.05.2006
(51) Int. Cl.: H05K 13/04, H05K 13/08

(54) **Virtual preventive inspection system for mounter and method for controlling mounter using the same**

(71) Applicant: Mirae Corporation, Chungcheongnam-do (KR)
(72) Inventor: Jung, Yun Gi, Gyeonggi-do (KR); Kim, Young Joo, Giheung-gu, Yongin-si Gyeonggi-do (KR); Hwang, Heung Seon, Cheonan-si, Chungcheongnam-do (KR)
(74) Representative: Meissner, Bolte & Partner

(57) **Abstract**

A virtual preventive inspection system for a mounter and a method for controlling the mounter are disclosed. The system performs animations and simulations for maintenance and repair procedures of assemblies included in a mounter, through virtual models, and for a maintenance procedure for a certain part of the mounter, such that it can protect users from danger and the real mounter from damage when the mounter is maintained. Therefore, the present invention can allow anyone to perform preventive maintenance and repair of the mounter.

## Description

This application claims the benefit of the Korean Patent Application No. 10-2004-0090277, filed on 8 November, 2004, which is hereby incorporated by reference as if fully set forth herein.

### BACKGROUND OF THE INVENTION

### Field of the Invention

The present invention relates to a mounter system, and more particularly, to a virtual preventive inspection system for a mounter and a method for controlling the mounter using the same, which are capable of providing virtual environment for preventive repair and maintenance of a mounter through animation and simulation of the mounter.

### Discussion of the Related Art

Generally, a mounter is indicative of equipment which automatically mounts parts, such as various chips, resistors, capacitors, transistors, etc., on a circuit board.

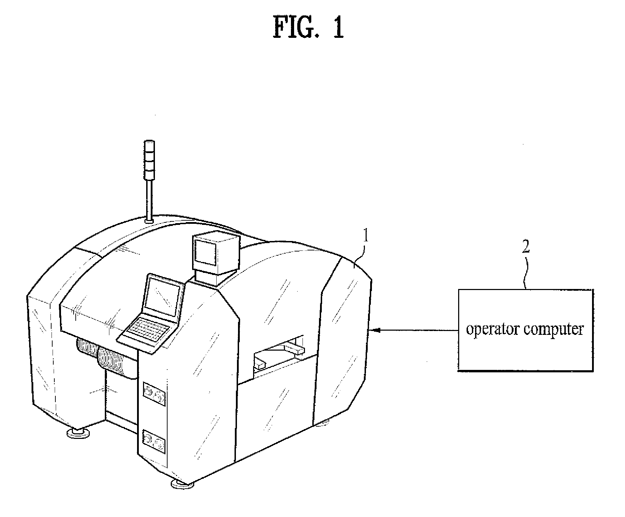

FIG. 1 illustrates a schematic diagram of a conventional mounter, which includes machine 1 and an operator computer 2.

The machine 1 is actually operated to mount parts thereon.

The operator computer 2 executes driving control of the machine 1. Therefore, an operator can control starting, driving and administration of the machine 1 through an operation program included in the operator computer 2.

On the other hand, since the mounter is equipment having a complicated structure, there exist various dangerous elements when a user actually manipulates the mounter. Especially, the mounter may be damaged when the mounter is actually repaired.

Therefore, before actually performing repair/maintenance of the mounter, users must correctly and sufficiently study the mounter to acquire technological knowledge necessary for repair/maintenance.

However, at the present stage, since a manual including only whole structures and functions for the mounter is provided, the conventional method requires much education time until users can skillfully deal with or maintain a new mounter. Also, the users are may have accidents and the mounter may be further damaged, while maintaining and repairing the mounter.

### SUMMARY OF THE INVENTION

Accordingly, the present invention is directed to a virtual preventive inspection system for a mounter, and a method for controlling the mounter using the system that substantially obviate one or more problems due to limitations and disadvantages of the related art.

An object of the present invention is to provide a virtual preventive inspection system for a mounter, and a method for controlling the mounter using the system, which are capable of allowing users to sufficiently acquire technology necessary for maintenance and repair of a real mounter through animation and simulation of the real mounter before manipulating a real mounter.

Another object of the present invention is to provide a virtual preventive inspection system for a mounter, and a method for controlling the mounter using the system, which is capable of generating codes for types of maintenance and repair of a real mounter such that maintenance and repair of the real mounter can be controlled based on the codes which correspond to the types of maintenance and repair, respectively.

A further object of the present invention is to provide a virtual preventive inspection system for a mounter, and a method for controlling the mounter using the system, which is capable of generating codes based on repair items or maintenance items corresponding to malfunction symptoms of a real mounter, such that users can easily acquire knowledge for repair and maintenance of the real mounter.

Additional advantages, objects, and features of the invention will be set forth in part in the description which follows and in part will become apparent to those having ordinary skill in the art upon examination of the following or may be learned from practice of the invention. The objectives and other advantages of the invention may be realized and attained by the structure particularly pointed out in the written description and claims hereof as well as the appended drawings.

To achieve these objects and other advantages and in accordance with the purpose of the invention, as embodied and broadly described herein, a virtual preventive inspection mounter system comprising: a mounter composed of a plurality of assemblies; and an operator computer for searching virtual mounter models related to maintenance and repair of the mounter, and for displaying maintenance and repair procedures as motion control of the searched virtual mounter model is performed.

Preferably, the operator computer includes: an operation program for executing operation control of the mounter; and a maintenance program for searching a virtual model corresponding to a particular code which is inputted thereto, and for displaying the maintenance and repair procedures as the motion control of the virtual model is performed. Here, the code includes procedure numbers to classify the maintenance and repair procedures of the mounter. Also, the system further comprises a database for storing virtual models, which perform the maintenance and repair procedures based on the procedure numbers, respectively. Therefore, the operator computer creates codes for malfunctions to identify symptoms for the malfunctions of the mounter, and stores the virtual models in the database in order to describe the symptoms for the malfunctions based on the codes identifying the malfunctions, wherein the virtual models perform animation or simulation. Also, the codes are stored in the database, associating with the procedures number of the maintenance and repair procedures of the mounter, respectively.

Preferably, the system further comprises a measurement means for performing electrical and mechanical measurement, wherein the measurement means is installed to each assembly of the mounter. Here, the operator computer receives measurement information from the measurement means and checks as to whether malfunctions of each assembly occurs or whether maintenance is performed.

Preferably, the system further comprises a count means for checking driving time of each assembly of the mounter. Here, the operator computer: previously sets a periodical maintenance period of each assembly of the mounter; determines as to whether the periodical maintenance period is reached on the basis of the check result of the driving time which is provided from the count means; searches a virtual model related to the maintenance procedure for a corresponding assembly whose periodical maintenance period is reached; and displays the maintenance procedure of the assembly as the virtual model related to the maintenance performs animation or simulation.

Preferably, the virtual model visually performs disassembling and assembling according to maintenance and repair procedures.

In another aspect of the present invention, a virtual preventive inspection mounter system comprising: a mounter for installing parts in a circuit board; and an operator computer including at least one maintenance program, which executes animation for maintenance and repair procedures of the mounter through an animation model which is vitually formed, in multi-dimensions, from each assembly included in the mounter.

Preferably, the operator computer further comprises: a operating program for executing operation control of the mounter; and a counter program which provides a command to the maintenance program, wherein the command is an instruction to execute animation of a maintenance procedure through an animation model of the assembly when a periodical maintenance period of the assembly is expired, in which the periodical maintenance period is calculated as the driving time of the assembly is checked.

Preferably, the system further comprises a database for storing animation models, which show maintenance and repair procedures of the assemblies, respectively. Here, the database stores the animation models therein, associating with inherent codes allocated to the animation models, respectively.

Preferably, the animation model performs disassembling or assembling animation according to the maintenance and repair procedures.

In further aspect of the present invention, a method for controlling a virtual preventive inspection mounter system, comprising the steps of: storing virtual models for maintenance and repair procedures of a mounter and a plurality of assemblies included in the mounter, associating inherent numbers with the virtual models, respectively; searching a virtual model according to a corresponding inherent number which is inputted; and executing animation through the searched virtual model.

In still further aspect of the present invention, a method for controlling a virtual preventive inspection mounter system, comprising the steps of: storing virtual models for maintenance and repair procedure sequences of a mounter and a plurality of assemblies included in the mounter; checking as to whether malfunctions of the assemblies occur; searching virtual models to show symptoms of malfunctions, which occur in the assemblies, and repair procedures corresponding to the malfunctions; executing animations for the malfunction symptoms and for the repair procedures through the searched virtual models.

In yet another aspect of the present invention, a method for controlling a virtual preventive inspection mounter system, comprising the steps of: storing virtual models for maintenance procedure sequence of a mounter and a plurality of assemblies included in the mounter; previously setting periodical maintenance periods of the assemblies, respectively; checking driving times of the assemblies, respectively; determining as to whether the periodical maintenance periods of the assemblies are reached, respectively; searching a virtual model for a corresponding assembly whose periodical maintenance period is reached; and executing animation for the periodical maintenance procedure through the searched virtual model.

It is to be understood that both the foregoing general description and the following detailed description of the present invention are exemplary and explanatory and are intended to provide further explanation of the invention as claimed.

### BRIEF DESCRIPTION OF THE DRAWINGS

The accompanying drawings, which are included to provide a further understanding of the invention and are incorporated in and constitute a part of this application, illustrate embodiment(s) of the invention and together with the description serve to explain the principle of the invention. In the drawings:

FIG. 1 illustrates a schematic diagram of a conventional mounter system;

FIG. 2 illustrates a virtual preventive inspection system for a mounter according to a first embodiment of the present invention;

FIG. 3 illustrates a flow chart describing a repair process of a mounter according to a first embodiment of the present invention;

FIG. 4 illustrates a flow chart describing a repair/maintenance process of a mounter according to a second embodiment of the present invention; and

FIG. 5 illustrates a flow chart describing a periodical repair process of a mounter according to a third embodiment of the present invention.

### DETAILED DESCRIPTION OF THE INVENTION

Reference will now be made in detail to the preferred embodiments of the present invention, examples of which are illustrated in the accompanying drawings. Wherever possible, the same reference numbers will be used throughout the drawings to refer to the same or like parts.

Referring to the drawings, a virtual preventive inspection for a mounter, and a method for controlling the mounter using the system, according to the preferred embodiment of the present invention, will be described in detail below.

The present invention serves to provide working procedures for maintenance/repair of a real mounter through mounter animation or mounter simulation using a virtual mounter model.

Especially, the present invention encodes experience, or history, of maintenance/repair of a real mounter, which are previously performed, to create codes corresponding thereto.

Therefore, when a user selects a code corresponding to a presently created error, the present invention serves to show repair or maintenance procedure corresponding to the error through mounter animation or to perform repair or maintenance procedure through mounter simulation, thereby providing the procedure and result for the repair or maintenance of the real mounter.

Namely, the present invention creates codes with respect to mounters, in which the codes correspond to maintenance items and to repair items corresponding to possibly generated malfunctions. The virtual mounter models based on codes are stored therein. When a code is inputted, a corresponding virtual mounter model shows a maintenance procedure or a repair procedure, etc. on a display.

On the other hand, the present invention is implemented such that, when the maintenance and repair procedures are animated or simulated by virtual mounter model, manual and automatic procedures and a periodical maintenance procedure can be supported. The manual procedure is performed by user code input. The automatic procedure is performed such that, after a state as to whether malfunction occurs is checked by a measurement result of a real mounter, a maintenance procedure or a repair procedure is performed according to a corresponding malfunction. The periodical maintenance procedure is performed on the basis of calculation of operation time of each assembly, considering each assembly included in the real mounter.

The virtual preventive inspection system for a mounter according to the present invention shows virtual work environment for preventive maintenance and repair of a real mounter through an animation model or a simulation model.

More specifically, such a virtual preventive inspection system will be described in detail below.

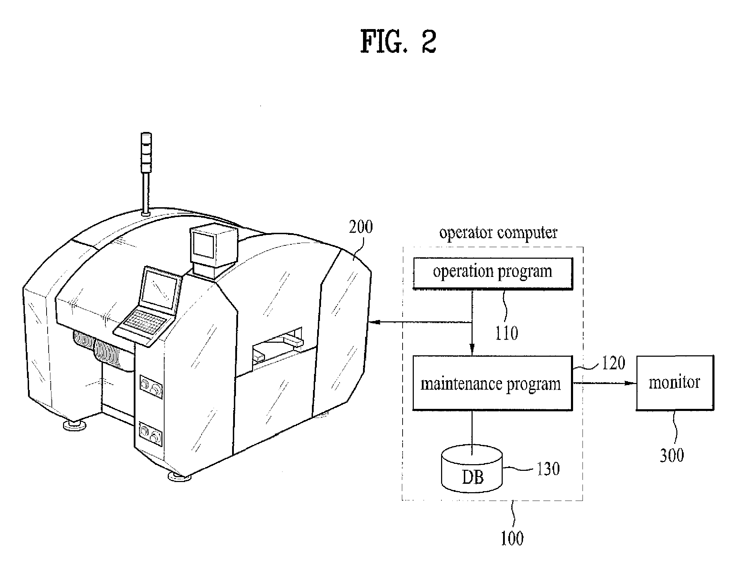

FIG. 2 illustrates a virtual preventive inspection system for a mounter according to a first embodiment of the present invention.

As shown in FIG. 2, the virtual preventive inspection system includes a mounter 200, an operator computer 100, and a monitor 300.

The mounter 200 is equipment which serves to actually mount certain parts on a circuit board.

The operator computer 100 serves to perform operation control of the mounter 200. Especially, the operator computer 100 provides preventive repair and maintenance procedures using a virtual model through user interface.

The monitor 300 serves to display information according to programs installed in the operator computer 100.

As described above, the mounter 200 composed of a plurality of assemblies is equipment which actually mounts certain parts on a circuit board, for example, Printed Wiring Board (PWB).

The monitor 300 displays operation environments of an operation program 110 included in the operator computer 100 and of a maintenance program 120.

Especially, the operator computer 100 includes the operation program 110, the maintenance program 120, and a database (DB) 130.

The operation program 110 executes operation control for a conventional mounter.

The maintenance program 120 executes motion control of a virtual model (namely, an animation model or a simulation model which is created from forms of assemblies included in the mounter, in multi-dimensions), singly or by associating with the operation program 110. Therefore, the virtual model shows maintenance and repair procedures through the monitor.

The database (DB) 130 stores virtual models showing the maintenance and repair procedures.

The maintenance program 120 serves to perform animation or simulation for the maintenance and repair procedures such that a virtual model can show the procedures.

Here, the database 130 stores virtual models therein, in which the virtual models perform animation or simulation, based on each procedure number, in order to show each maintenance and repair procedure, respectively.

The virtual models stored in the database 130 are allocated by inherent codes, respectively. Namely, such inherent codes are a type of procedure number to identify the respective maintenance and repair procedure. Therefore, when a user inputs one of the codes, maintenance and repair procedures corresponding to the code can be performed. Also, the database 130 stores descriptions of symptoms for malfunctions of the mounter 200 and virtual models for the descriptions of the symptoms.

Namely, the operator computer 100 creates virtual models based on the symptoms of previously generated malfunctions, and then stores them in the database 130. Also, at the same time, the operator computer 100 allocates codes for classifying the malfunction symptoms to the virtual models based on the symptoms. In other words, the operator computer 100 encodes each malfunction, in order to classify the malfunctions of the mounter 200 based on symptoms, and then stores the virtual models in the database 130, in which the virtual models serves to describe each symptom through animation or simulation according to the codes.

Especially, the codes based on the malfunction symptoms are stored in the database 130, and associated with the procedure numbers of maintenance and repair procedures of a mounter.

Therefore, when a malfunction occurs in the mounter 200, the operator computer 100 displays symptoms of the malfunction through a virtual model stored in the database 130, and then performs animation or simulation of maintenance and repair procedures to deal with the malfunction corresponding to the symptoms.

In addition, the virtual preventive inspection system of the present invention may further include a measurement means (not shown) for executing electrical and mechanical measurement, in which the measurement means is located in each assembly off the mounter 200. Therefore, the operator computer 100 receives measurement information from the measurement means of each assembly to check states as to whether a corresponding assembly has malfunctioned or whether maintenance needs to be performed in the corresponding assembly.

Also, the virtual preventive inspection system of the present invention may further include a count means (not shown) for checking driving time for each assembly. Especially, the count means calculates driving time from when each assembly is installed in the mounter 200 and operated, and then provides the calculated driving time in order to identify a periodical maintenance procedure, which will be described later. Namely, the count means serves to monitor lifetime of each assembly.

Accordingly, the operator computer 100 collects the check results of driving times of assemblies from the count means, respectively, and then accumulates the collected driving times of the assemblies. Afterwards, the operator computer 100 compares the periodical maintenance periods based on the assemblies with the accumulated driving times, respectively, to determine as to whether the accumulated driving times are periodical maintenance periods, respectively.

When the accumulated driving time of an assembly is a periodical maintenance period, the operator computer 100 searches a virtual model related to the maintenance for a corresponding assembly in the database 130. After that, the searched virtual model performs animation or simulation. Namely, the periodical maintenance procedure of the assembly whose periodical maintenance period is expired is displayed through the searched virtual model. To this end, the operator computer 100 must previously set the periodical maintenance periods of the assemblies, respectively.

On the other hand, the count means is preferably implemented with a count program which provides a command to the maintenance program 120, in which the command is an instruction to execute animation of a maintenance procedure through an animation model of the assembly when a periodical maintenance period of the assembly is expired, in which the periodical maintenance period is calculated as the driving time of the assembly is checked.

As described above, the present invention can automatically check the periodical maintenance period, and then perform animation for a corresponding procedure through a virtual model.

The most important thing of the present invention is related to operations of the maintenance program of the programs installed in the operator computer 100.

The operations of the maintenance program will be described as follows.

When a particular code is inputted, the maintenance program 120 in the operator computer 100 searches for a virtual model corresponding to the inputted code in the database 130. Afterwards, the maintenance program 120 executes operation control of the searched virtual model to display a maintenance and repair procedure or a description for malfunction symptoms and a repair procedure corresponding to the malfunction symptoms on the monitor 300.

Especially, when the operation control of the virtual model is executed, the virtual model is displayed on the monitor 300, such that it is disassembled and assembled according to a corresponding maintenance and repair procedure or a description of a malfunction symptom and a repair procedure corresponding to the malfunction symptom.

Although the operations of the operator computer 100 result from the maintenance program being used, it doesn't matter whether the subject of the operations is regarded as the operator computer 100 from an entire configuration point of view.

The following is a description of exemplary examples where the maintenance program 120 executes animation or simulation for maintenance and repair procedures of the mounter 200. Especially, embodiments of the maintenance procedure will be described.

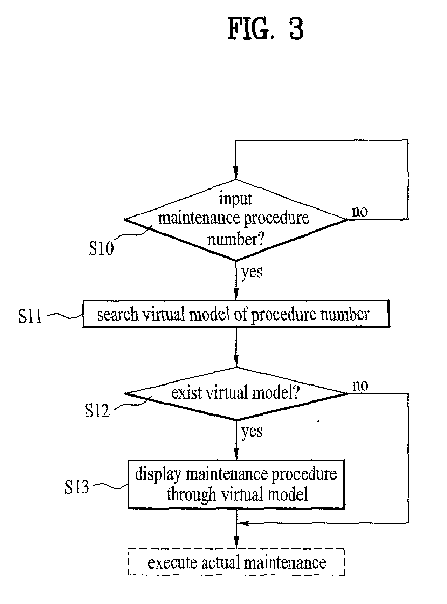

Firstly, a manual maintenance procedure will be described in detail, referring to FIG. 3.

FIG. 3 illustrates a flow chart describing a repair process of a mounter according to a first embodiment of the present invention.

As shown in FIG. 3, the operator computer previously stores virtual models in the database, in which the virtual models are formed, in multi-dimensions, from a real mounter, which installs certain parts on a circuit board, and a plurality of assemblies included in the real mounter, such that the virtual models simulate maintenance sequence (procedure). The virtual models are associated with inherent codes corresponding to procedure numbers such that maintenance of the mounter can be classified on the basis of procedures.

Afterwards, when a user inputs an inherent code to the operator computer, the operator computer searches a virtual model corresponding to the inputted inherent number in the database in steps S10 and S11.

When the virtual model exists in the database, the operator computer performs animation for the maintenance procedure requested by the user through the searched virtual model in step S13. Namely, the operator computer displays the maintenance procedure on the monitor via the searched virtual model.

After that, the user can actually execute a maintenance procedure for the real mounter.

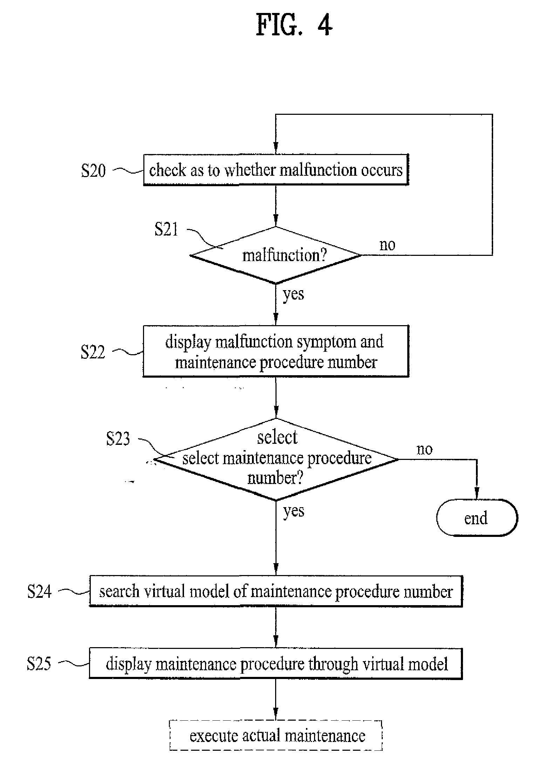

Secondly, an automatic maintenance and repair procedure will be described in detail, referring to FIG. 4.

FIG. 4 illustrates a flow chart describing a repair/maintenance process of a mounter according to a second embodiment of the present invention.

As shown in FIG. 4, the operator computer previously stores virtual models in the database, in which the virtual models are formed, in multi-dimensions, from a real mounter, which installs certain parts on a circuit board, and a plurality of assemblies included in the real mounter, such that the virtual models simulate maintenance and repair sequences (procedures). The virtual models are associated with inherent codes corresponding to procedure numbers such that maintenance and repair of the mounter can be classified on the basis of procedures.

Also, the measurement means is located at each of the assemblies and checks as to whether malfunctions of the assemblies occur in step S20.

Based on the check result, the operator computer searches virtual models in the database to show symptoms of generated malfunctions and repair procedures corresponding to the generated malfunctions in step S24. Afterwards, the searched virtual models perform animations for the symptoms of the malfunctions, and for solution to the malfunctions or for searched repair procedure in step S25.

Preferably, the following operations are further executed before the virtual models are searched to show the symptoms of generated malfunctions and the repair procedure corresponding to the malfunctions.

Namely, when the operator computer determines as an assembly has malfunctioned, it displays inherent number corresponding to the symptom of the generated malfunction, and inherent number of repair procedure corresponding to the symptom in step S22. Also, when a user selects the inherent number of the malfunction symptom, a virtual model is searched and displayed on the monitor, thereby showing the malfunction symptom.

On the other hand, when the user selects the inherent number of repair procedure corresponding to the symptom in step S23, a virtual model corresponding to the corresponding repair procedure number is searched for in the database in step S24. Afterwards, the searched virtual models perform animation for the repair procedures in step S25.

After that, the user can actually perform a repair procedure for the malfunctioned assembly in the real mounter.

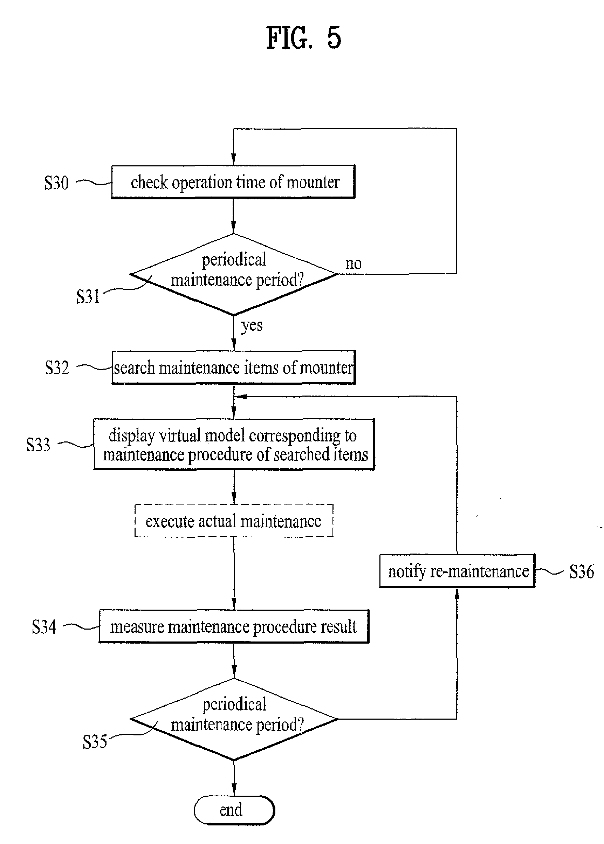

Thirdly, a periodical maintenance procedure will be described in detail, referring to FIG. 5.

FIG. 5 illustrates a flow chart describing a periodical repair procedure of a mounter according to a third embodiment of the present invention.

As shown in FIG. 5, the operator computer previously stores virtual models in the database, in which the virtual models are formed, in multi-dimensions, from a real mounter, which installs certain parts on a circuit board, and a plurality of assemblies included in the real mounter, such that the virtual models simulate maintenance sequences (procedures). The virtual models are associated with inherent codes corresponding to procedure numbers such that maintenance of the mounter can be classified on the basis of procedures. Also, the operator computer previously sets periodical maintenance periods based on assemblies of the mounter, respectively.

The count means checks actual driving time of each assembly of the mounter in step S30. Since the actual driving time of each assembly is different from that of the mounter, weights indicating actual driving time of each assembly are set based on the total driving time of the mounter which is calculated from procedures installing certain parts to a circuit board, and then the actual driving time of each assembly is checked.

For example, a mounter is composed of assemblies, such as a base frame, a PWB transfer block, a component feeding block, a positioning block. Here, when a procedure of mounting a part to a circuit board is performed, such a procedure takes 10 hours, therefore, operation time of the mounter needs to be 10 hours.

On the other hand, although the mounter is operated for 10 hours, real driving time of each assembly may be less than 10 hours. Here, the following driving times may be actual driving times: namely, driving time of base frame of 10 hours; driving time of an entrance conveyer in a PWB transfer block of 9 hours; driving time of work conveyer of 10 hours; and driving time of an existing conveyer of 9 hours. Also, driving times of a feeder base and a feeder in the component feeding block may be 9 hours actual driving time.

Therefore, weights indicating actual driving times of the assemblies are set, respectively, and then actual driving time is checked by comparing with the total work time.

Also, a state is determined as to whether periodical maintenance periods for assemblies have been reached. Therefore, when a result of a determination is that a periodical maintenance period of an assembly has been reached, maintenance items for assemblies of the mounter are searched in the database in step S31 and S32. Namely, when the operator computer determines that the periodical maintenance period of the assembly has been reached, it searches for a virtual model of the assembly in the database.

Afterwards, the operator computer displays the virtual model corresponding to a searched maintenance item procedure through the monitor in step S33. Namely, the operator computer performs animation for the periodical maintenance procedure via the searched virtual model.

After that, the user can actually perform a maintenance procedure for the assembly in the real mounter, which requires a periodical maintenance procedure.

Also, the measurement means installed in an assembly measures the result of the periodical maintenance procedure, in which the assembly is located in a place where a periodical maintenance is executed, and then checks as to whether there is a malfunction resulting from the maintenance procedure in step S34.

When no malfunctions occur in a corresponding maintained assembly, the operator computer notifies the user that the periodical maintenance procedure has been normally performed. On the other hand, when a malfunction occurs in a corresponding assembly, the operator computer notifies the user, in steps S35 and S36, that the maintenance procedure needs to be re-performed.

As described above, since the virtual preventive inspection mounter system according to the present invention performs animations and simulations for maintenance and repair procedures of assemblies included in a mounter, through virtual models, and for a maintenance procedure for a certain part of the mounter, it can protect users from danger and the real mounter from damage when the mounter is maintained, and therefore it can allow anyone to perform preventive maintenance and repair of the mounter.

It will be apparent to those skilled in the art that various modifications and variations can be made in the present invention without departing from the spirit or scope of the inventions. Thus, it is intended that the present invention covers the modifications and variations of this invention provided they come within the scope of the appended claims and their equivalents.

## Claims

1. A virtual preventive inspection mounter system comprising:
a mounter composed of a plurality of assemblies; and
an operator computer for searching virtual mounter models related to maintenance and repair of the mounter, and for displaying maintenance and repair procedures as motion control of the searched virtual mounter model is performed.

2. The system of claim 1, wherein the operator computer includes:
an operation program for executing operation control of the mounter; and
a maintenance program for searching a virtual model corresponding to a particular code which is inputted thereto, and for displaying the maintenance and repair procedures as the motion control of the virtual model is performed.

3. The system of claim 2, wherein the code includes procedure numbers to classify the maintenance and repair procedures of the mounter.

4. The system of claim 3, further comprising a database for storing virtual models, which perform the maintenance and repair procedures based on the procedure numbers, respectively.

5. The system of claim 4, wherein the operator computer creates codes for malfunctions to identify symptoms for the malfunctions of the mounter, and stores the virtual models in the database in order to describe the symptoms for the malfunctions based on the codes identifying the malfunctions, wherein the virtual models perform animation or simulation.

6. The system of claim 5, wherein the codes are stored in the database, associating with the procedures number of the maintenance and repair procedures of the mounter, respectively.

7. The system of claim 1, further comprising a measurement means for performing electrical and mechanical measurement, wherein the measurement means is installed to each assembly of the mounter.

8. The system of claim 7, wherein the operator computer receives measurement information from the measurement means and checks as to whether malfunctions of each assembly occurs or whether maintenance is performed.

9. The system of claim 1, further comprising a count means for checking driving time of each assembly of the mounter.

10. The system of claim 9, wherein the operator computer: previously sets a periodical maintenance period of each assembly of the mounter; determines as to whether the periodical maintenance period is reached on the basis of the check result of the driving time which is provided from the count means; searches a virtual model related to the maintenance procedure for a corresponding assembly whose periodical maintenance period is reached; and displays the maintenance procedure of the assembly as the virtual model related to the maintenance performs animation or simulation.

11. The system of claim 1, wherein the virtual model visually performs disassembling and assembling according to maintenance and repair procedures.

12. A virtual preventive inspection mounter system comprising:
a mounter for installing parts in a circuit board; and
an operator computer including at least one maintenance program, which executes animation for maintenance and repair procedures of the mounter through an animation model which is vitually formed, in multi-dimensions, from each assembly included in the mounter.

13. The system of claim 12, wherein the operator computer further comprises:
a operating program for executing operation control of the mounter; and
a counter program which provides a command to the maintenance program, wherein the command is an instruction to execute animation of a maintenance procedure through an animation model of the assembly when a periodical maintenance period of the assembly is expired, in which the periodical maintenance period is calculated as the driving time of the assembly is checked.

14. The system of claim 12, further comprising a database for storing animation models, which show maintenance and repair procedures of the assemblies, respectively.

15. The system of claim 14, wherein the database stores the animation models therein, associating with inherent codes allocated to the animation models, respectively.

16. The system of claim 12, wherein the animation model performs disassembling or assembling animation according to the maintenance and repair procedures.

17. A method for controlling a virtual preventive inspection mounter system, comprising the steps of:
storing virtual models for maintenance and repair procedures of a mounter and a plurality of assemblies included in the mounter, associating inherent numbers with the virtual models, respectively;
searching a virtual model according to a corresponding inherent number which is inputted; and
executing animation through the searched virtual model.

18. A method for controlling a virtual preventive inspection mounter system, comprising the steps of:
storing virtual models for maintenance and repair procedure sequences of a mounter and a plurality of assemblies included in the mounter;
checking as to whether malfunctions of the assemblies occur;
searching virtual models to show symptoms of malfunctions, which occur in the assemblies, and repair procedures corresponding to the malfunctions;
executing animations for the malfunction symptoms and for the repair procedures through the searched virtual models.

19. A method for controlling a virtual preventive inspection mounter system, comprising the steps of:
storing virtual models for maintenance procedure sequence of a mounter and a plurality of assemblies included in the mounter
previously setting periodical maintenance periods of the assemblies, respectively;
checking driving times of the assemblies, respectively;
determining as to whether the periodical maintenance periods of the assemblies are reached, respectively;
searching a virtual model for a corresponding assembly whose periodical maintenance period is reached; and
executing animation for the periodical maintenance procedure through the searched virtual model.
